# EUROPEAN PATENT SPECIFICATION

(11) **EP 3 296 840 B1**
(45) Date of publication and mention of the grant of the patent: **31.07.2019**
(21) Application number: 17191854.3
(22) Date of filing: 19.09.2017
(51) Int. Cl.: G05F 1/565, G05F 1/577

(54) **LOAD MONITOR, POWER SUPPLY SYSTEM BASED ON MULTI-CORE ARCHITECTURE, AND VOLTAGE REGULATION METHOD**
LASTÜBERWACHUNG, STROMVERSORGUNGSSYSTEM BASIEREND AUF EINER MEHRADRIGEN ARCHITEKTUR UND SPANNUNGSREGELUNGSVERFAHREN
MONITEUR DE CHARGE, SYSTÈME D'ALIMENTATION ÉLECTRIQUE BASÉ SUR UNE ARCHITECTURE MULTICOEUR ET PROCÉDÉ DE RÉGULATION DE TENSION

(30) Priority: 20.09.2016 CN 201610834448
(43) Date of publication of application: 21.03.2018
(73) Proprietor: HUAWEI TECHNOLOGIES CO., LTD., Guangdong 518129 (CN)
(72) Inventor: TSAO, Youming, Shenzhen, Guangdong 518129 (CN); YAO, Cong, Shenzhen, Guangdong 518129 (CN); MAO, Xiangyu, Shenzhen, Guangdong 518129 (CN)
(74) Representative: Pfenning, Meinig & Partner mbB

(56) References cited:
- EP-A2- 1 736 851
- WO-A1-2013/137862
- US-A1- 2009 089 543
- US-A1- 2010 115 304
- US-A1- 2012 054 515
- LEE WOOJOO ET AL: "VRCon: Dynamic reconfiguration of voltage regulators in a multicore platform", 2014 DESIGN, AUTOMATION & TEST IN EUROPE CONFERENCE & EXHIBITION (DATE), EDAA, 24 March 2014 (2014-03-24), pages 1-6, XP032589544, DOI: 10.7873/DATE2014.378 [retrieved on 2014-04-17]

## Description

### TECHNICAL FIELD

The present invention relates to the field of communications technologies, and in particular, to a load monitor, a power supply system based on a multi-core architecture, and a voltage regulation method.

### BACKGROUND

A multi-core (English: core) architecture means that two or more cores that independently operate are integrated in an integrated circuit (IC for short). The core may be a central processing unit (English: Central Processing Unit, CPU for short), a video decoder (English: Video Decoder), a video encoder (English: Video Decoder), or the like. In an existing multi-core architecture, multiple cores share a same voltage source, and operating voltages of all cores are the same. Higher core load indicates a higher operating voltage required. When each core has different load, to meet a requirement for an operating voltage of a core with maximum load, an operating voltage of each core needs to be the operating voltage of the core with the maximum load. As a result, a core with low load operates at a high operating voltage, and this causes a power consumption waste of the core with the low load, and further increases overall power consumption of the multi-core architecture.

WO 2013/137862 A1 describes a method for determining whether a number of stalled cores of a multicore processor is greater than a stall threshold. If so, a recommendation may be made that an operating frequency of system agent circuitry of the processor be increased. Then based on multiple recommendations, a candidate operating frequency of the system agent circuitry can be set.

US 2010/115304 describes methods and apparatus relating to power management for multiple processor cores are described. In one embodiment, one or more techniques may be utilized locally (e.g., on a per core basis) to manage power consumption in a processor. In another embodiment, power may be distributed among different power planes of a processor based on energy-based considerations. Other embodiments are also disclosed and claimed.

In US 2012/054515 A1 a system includes one or more processor cores, and a voltage regulator that provides an operating voltage to the one or more processor cores in response to receiving a voltage identifier signal that is indicative of the operating voltage. The system also includes a power management unit that may provide a first voltage identifier signal corresponding to a first operating voltage in response to determining that the processor cores are operating in a first operating state in which the one or more processor cores may draw up to a maximum load current. The power management unit may also provide a second voltage identifier signal corresponding to a second operating voltage, which is less than the first operating voltage, in response to determining that the processor cores are operating in a second operating state in which the processor cores are incapable of an increase in load current above a predetermined amount.

According to EP 1 736 851 A2 power may be controlled for a multi-core processor that includes a processor having a first core and a second core. A first power conversion unit independently supplies a supply voltage to the first core, and a second power conversion unit independently supplies a supply voltage to the second core. The first core can be configured to supply a voltage identification signal for the first power conversion unit, and the second core can be configured to supply a voltage identification signal for the second power conversion unit that is different from the voltage identification signal for the first core.

In US 2009/089543 A1 methods and apparatus to improve integrated circuit (IC) performance across a range of operating conditions and/or physical constraints are described. In one embodiment, an operating parameter of one or more of processor cores may be adjusted in response to a change in the activity level of processor cores (e.g., the number of active processor cores) and/or a comparison of one or more operating conditions and one or more corresponding threshold values. Other embodiments are also described.

LEE WOOJOO ET AL describe in "VRCon: Dynamic reconfiguration of voltage regulators in a multicore platform", 2014 DESIGN, AUTOMATION & TEST IN EUROPE CONFERENCE & EXHIBITION (DATE), EDAA, (20140324), doi:10.7873/DATE2014.378, pages 1 - 6, XP032589544; that the emerging trend toward utilizing chip multi-core processors (CMPs) that support dynamic voltage and frequency scaling (DVFS) is driven by user requirements for high performance and low power. To overcome limitations of the conventional chip-wide DVFS and achieve the maximum possible energy saving, per-core DVFS is being enabled in the recent CMP offerings. While power consumed by the CMP is reduced by per-core DVFS, power dissipated by many voltage regulators (VRs) needed to support per-core DVFS becomes critical. This paper focuses on the dynamic control of the VRs in a CMP platform. Starting with a proposed platform with a configurable VR-to-core power distribution network, two optimization methods are presented to maximize the system-wide energy savings: (i) reactive VR consolidation to reconfigure the network for maximizing the power conversion efficiency of the VRs performed under the pre-determined DVFS levels for the cores, and (ii) proactive VR consolidation to determine new DVFS levels for maximizing the total energy savings without any performance degradation. Results from detailed experiments demonstrate up to 35% VR energy loss reduction and 14% total energy saving.

### SUMMARY

According to the present application, the above objects are solved by the claimed matter according to the independent claims. Embodiments of the present a power supply system based on a multi-core architecture, and a voltage regulation method, so as to reduce overall power consumption of the multi-core architecture.

A first aspect of the embodiments of the present invention discloses a load monitor, where the load monitor is applied to a multi-core architecture, the load monitor is configured to monitor a load status of a core, and control, according to the load status of the core, a low dropout regulator LDO to output a voltage to the core, and the load monitor includes a control module and at least one monitoring module, where
a monitoring end of the monitoring module is connected to a signal output end of the core, an output end of the monitoring module is connected to an input end of the control module, a control end of the control module is connected to an input end of the monitoring module, an output end of the control module is connected to a control end of the LDO, an output end of the LDO is connected to a voltage input end of the core, and the control module is configured to control the monitoring module to operate or power off; and
when the monitoring module operates, the monitoring module monitors the load status of the core, the monitoring module sends the load status of the core to the control module, the control module generates, according to the load status of the core, a voltage control signal and sends the voltage control signal to the LDO, the voltage control signal is used to control the LDO to output a corresponding voltage to the core, and the LDO is configured to output, according to different voltage control signals, different voltages to supply power to the core.

The load monitor can monitor the load status of the core, generate the voltage control signal according to the load status, and send the voltage control signal to the LDO, so that the LDO supplies power to the core. In the multi-core architecture, each load monitor can regulate, according to a load status of a core connected to the load monitor, an operating voltage of the core, so as to adjust an operating frequency of the core. This can meet a requirement for different voltages and frequencies of multiple cores in the multi-core architecture, and further reduce overall power consumption of the multi-core architecture.

Optionally, to facilitate acquisition of the load status of the core by an external device, a system, or software, the load monitor further includes a read module, where the read module is connected to the monitoring module and the control module, the read module is configured to control the monitoring module and the control module to operate or power off, and when the monitoring module and the control module operate, read the load status detected by the monitoring module.

The read module can read at least one load status detected by at least one monitoring module, and the at least one load status read by the read module may be used by the external device, system, or software. The external device, system, or software can obtain the load status of the core in time to facilitate monitoring on the load status of the core performed by the external device, system, or software.

Optionally, the load status includes a load signal;
when the control module operates, the control module periodically outputs a sampling signal to the monitoring module, and in response to the sampling signal, the monitoring module samples a load signal inputted by the core; in a sampling period of the sampling signal, when the load signal is greater than a corresponding threshold, the monitoring module determines that the load signal is valid; and the monitoring module counts a quantity of times that the load signal is valid during the sampling period, and latches a load value of the valid load signal, so that the read module reads the load value.
This embodiment of the present invention provides an operating manner of the read module. The read module can periodically read the load status of the core.

Optionally, the voltage control signal includes an operating mode control signal, the operating mode control signal is used to control the LDO to be in different operating modes, and in different operating modes, the LDO outputs different voltages to supply power to the core.

In this embodiment of the present invention, multiple operating modes may be set for an LDO. In different operating modes, the LDO outputs different voltages to a core. The LDO determines its operating mode according to a voltage control signal outputted by a load monitor, so as to regulate a voltage and a frequency of the core. The LDO itself does not need to control an output voltage. Only the operating mode of the LDO needs to be set. A design of the LDO is simplified, and the load monitor can rapidly regulate the voltage and the frequency of the core.

A second aspect of the embodiments of the present invention discloses a power supply system that is based on a multi-core architecture, including a voltage source and N cores, and further including M low dropout regulators LDOs and N load monitors LMs that are disclosed in the first aspect of the embodiments of the present invention, where
an output end of the voltage source is connected to input ends of the M LDOs, an output end of a k^{th} LDO is connected to voltage input ends of X cores, a signal output end of an i^{th} core is connected to a monitoring end of a j^{th} LM, and an output end of the j^{th} LM is connected to a control end of the k^{th} LDO, where each LDO is connected to a different core, one core is connected to one LM, each core is connected to a different LM, both M and N are positive integers greater than or equal to 2, N is greater than or equal to M, X is a positive integer less than N, the k^{th} LDO is any one of the M LDOs, the i^{th} core is any one of the X cores, the j^{th} LM is any one of the N LMs, and both i and j are positive integers; and
the voltage source provides a supply voltage for the M LDOs, the j^{th} LM monitors a load status of the i^{th} core, generates a voltage control signal according to the load status, and sends the voltage control signal to the k^{th} LDO, the k^{th} LDO receives X voltage control signals sent by X LMs, determines a highest voltage control signal from the X voltage control signals, and outputs, according to a correspondence between a voltage control signal and an output voltage, a target output voltage corresponding to the highest voltage control signal to the X cores; and the target output voltage is less than or equal to the supply voltage.

An LM can control a supply voltage and a frequency of a core according to a load status of the core detected by the LM, so as to meet a requirement for different voltages and frequencies of multiple cores in a multi-core architecture, and reduce overall power consumption of the multi-core architecture.

A third aspect of the embodiments of the present invention discloses a voltage regulation method, including:
monitoring, by a j^{th} LM, a load status of an i^{th} core; and
generating, by the j^{th} LM according to a correspondence between a load status and a voltage control signal, a voltage control signal corresponding to the load status, and outputting the voltage control signal to a k^{th} LDO, so that the k^{th} LDO determines a highest voltage control signal from at least one received voltage control signal, and outputs, according to a correspondence between a voltage control signal and an output voltage, a target output voltage corresponding to the highest voltage control signal to the X cores connected to the k^{th} LDO, so that an operating voltage of the X cores is the target output voltage.

In this embodiment of the present invention, an operating voltage of each core can be regulated flexibly according to a load status of the core. Each core in a multi-core architecture operates in an optimal power-saving state, so as to reduce overall power consumption of the multi-core architecture.

Optionally, the method further includes:
monitoring, by the j^{th} LM, a current operating voltage of the i^{th} core; and
locking, by the j^{th} LM, the i^{th} core when the current operating voltage is greater than a preset value, and unlocking the i^{th} core only when the current operating voltage is less than or equal to the preset value.

The j^{th} LM is any one of N LMs in a power supply system based on the multi-core architecture, and each LM performs real-time monitoring on a load status of one core. Locking a core is a method for ensuring core performance when an operating voltage of the core is excessively high. Locking a core can stabilize an operating current of the core, and when a required voltage of the core is excessively high, avoid a problem that an unstable voltage outputted by an LDO results in an unstable operating current.

Optionally, the voltage control signal includes a first enable signal and a second enable signal, a magnitude of the voltage control signal is determined based on the first enable signal and the second enable signal, and different voltage control signals correspond to different operating modes.

For example, the first enable signal may be "0" or "1". The second enable signal may be "0" or "1". A combination of the first enable signal and second enable signal corresponds to four types of different voltage control signals. Each type of voltage control signal corresponds to one type of operating mode. Different voltage control signals correspond to different operating modes. In different operating modes, an LDO outputs different voltages and frequencies.

Optionally, the k^{th} LDO includes the following four operating modes: an active mode, a retention mode, a bypass mode, and a power-off mode.

In the active mode, a core is in an operating state. A voltage and current instantaneously outputted by an LDO to the core can meet a requirement for normal operation of the core. In the retention mode, the core is in a non-operating state, and retains only necessary internal status information. Most power consumption of the core comes from static power consumption. The LDO outputs an extremely low voltage, and in this case, the LDO is in a low power-consumption state. In the bypass mode, a voltage outputted by the LDO is all provided by an external voltage source. The voltage outputted by the LDO is a voltage of the external voltage source. In the power-off mode, power of the core is cut, and the core stops operating.

Optionally, the load status includes at least one of an idle time percentage, wait for interrupt (English: Wait for interrupt; WFI for short) duration, a temperature, or a cache hit rate.

Generally, a larger idle time percentage indicates lighter core load. Longer wait for interrupt duration indicates lighter core load. A higher temperature indicates heavier core load. A higher cache hit rate indicates heavier core load. The load status may include one or multiple combinations of the idle time percentage, the wait for interrupt duration, the temperature, and the cache hit rate.

In the embodiments of the present invention, a load monitor is applied to a multi-core architecture. The load monitor is configured to monitor a load status of a core, and control, according to the load status of the core, a low dropout regulator LDO to output a voltage to the core. The load monitor includes a control module and at least one monitoring module. A monitoring end of the monitoring module is separately connected to a signal output end of the core. An output end of the monitoring module is connected to an input end of the control module. A control end of the control module is connected to an input end of the monitoring module. An output end of the control module is connected to a control end of the LDO. An output end of the LDO is connected to a voltage input end of the core. The control module is configured to control the monitoring module to operate or power off.

When the monitoring module operates, the monitoring module monitors the load status of the core. The monitoring module sends the load status of the core to the control module. The control module generates, according to the load status of the core, a voltage control signal and sends the voltage control signal to the LDO. The voltage control signal is used to control the LDO to output a corresponding voltage to the core, and the LDO outputs, according to different voltage control signals, different voltages to supply power to the core. A load monitor is used to implement the embodiments of the present invention. Each load monitor can regulate an operating voltage and a frequency of each core according to a load status of each core, so as to meet a requirement for different voltages and frequencies of multiple cores in the multi-core architecture, and reduce overall power consumption of the multi-core architecture.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic diagram of a multi-core architecture according to an embodiment of the present invention;
FIG. 2 is a schematic structural diagram of a load monitor according to an embodiment of the present invention;
FIG. 3 is a schematic structural diagram of another load monitor according to an embodiment of the present invention;
FIG. 4 is a schematic structural diagram of a power supply system based on a multi-core architecture according to an embodiment of the present invention;
FIG. 5 is a schematic structural diagram of an LDO according to an embodiment of the present invention;
FIG. 6 is a schematic flowchart of a voltage regulation method according to an embodiment of the present invention; and
FIG. 7 is a schematic flowchart of another voltage regulation method according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

Embodiments of the present invention disclose a load monitor, a power supply system based on a multi-core architecture, and a voltage regulation method, so as to reduce overall power consumption of the multi-core architecture. Details are separately illustrated below.

For a better understanding of the embodiments of the present invention, the multi-core architecture disclosed in the embodiments of the present invention is first described below.

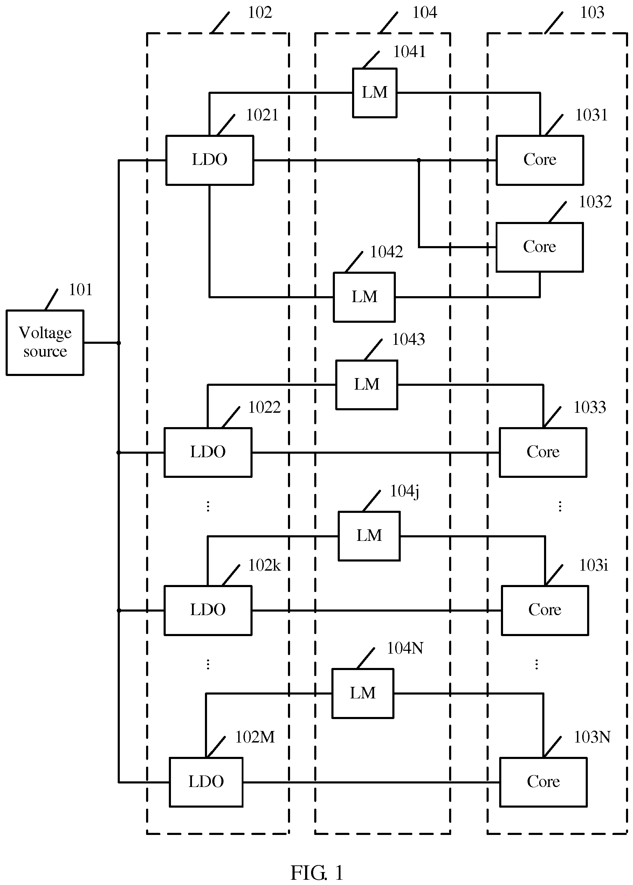

Referring to FIG. 1, FIG. 1 is a schematic diagram of a multi-core architecture according to an embodiment of the present invention. As shown in FIG. 1, the multi-core architecture includes a voltage source 101, N cores (for example, 1031, 1032, 1033, ..., and 103N in FIG. 1), M low dropout regulators (for example, 1021, 1022, ..., and 102M in FIG. 1), and N load monitors (for example, 1041, 1042, 1043, ..., and 104N in FIG. 1).

A core is an independent function module, for example, a central processing unit (English: Central Processing Unit, CPU for short), a video decoder (English: Video Decoder), a video encoder (English: Video Decoder), or the like.

The voltage source 101 provides a supply voltage for the low dropout regulators 1021, 1022, ..., and 102M. One load monitor (English: Load Monitor; LM for short) monitors a load status of one core. For example, the LM 1041 monitors a load status of the core 1031, the LM 1042 monitors a load status of the core 1032, ..., and the LM 104N monitors a load status of the core 103N. The load status may include parameters such as a load ratio, a voltage, a current, power, and a frequency that are of the core, and may also include parameters such as wait for interrupt (English: Wait for interrupt; WFI for short) duration, a cache hit rate, and an idle time percentage that are of the core. Generally, shorter wait for interrupt duration, a higher cache hit rate, and a smaller idle time percentage of a core all indicate heavier core load. The LM generates a voltage control signal according to the load status of the core, and sends the voltage control signal to a low dropout regulator (English: Low Dropout Regulator; LDO for short). For example, the LM 1041 generates a voltage control signal according to the load status of the core 1031, and sends the voltage control signal to the LDO 1021, the LM 1042 generates a voltage control signal according to the load status of the core 1032, and sends the voltage control signal to the LDO 1021, the LM 1043 generates a voltage control signal according to the load status of the core 1033, and sends the voltage control signal to the LDO 1022, ..., and the LM 104N generates a voltage control signal according to the load status of the core 103N, and sends the voltage control signal to the LDO 102M. The LDO outputs the voltage to the core according to the voltage control signal sent by the LM. Specifically, the LDO may determine, according to a voltage control signal sent by at least one core, a voltage control signal with a highest voltage from the voltage control signal sent by the at least one core. The LDO outputs a target output voltage corresponding to the voltage control signal with the highest voltage to the foregoing at least core according to a correspondence between a voltage control signal and an output voltage. For example, the LDO 1021 is used as an example. The LDO 1021 determines, according to a first voltage control signal sent by the LM 1041 and a second voltage control signal sent by the LM 1042, which voltage control signal between the first voltage control signal and the second voltage signal corresponds to a higher output voltage. If the first voltage control signal corresponds to a higher output voltage, the output voltage corresponding to the first voltage control signal is outputted to the core 1031 and core 1032. If the second voltage control signal corresponds to a higher output voltage, the output voltage corresponding to the second voltage control signal is outputted to the core 1031 and core 1032.

The LDO in FIG. 1 may be separated from the core, and may also be integrated on the core. When the LDO is integrated on the core, the LDO is an on-chip low dropout regulator (English: On-Chip Low Dropout Regulator; OCLDO for short). The foregoing M and N are positive integers greater than or equal to 2, and M is less than or equal to N. In this embodiment of the present invention, each load monitor can regulate an operating voltage of each core according to a load status of each core, and further adjust an operating frequency of each core, so as to meet a requirement for different voltages and frequencies of multiple cores in the multi-core architecture, and reduce overall power consumption of the multi-core architecture.

In a preferred embodiment, the foregoing M and N are equal, that is, one LDO corresponds to one core, one core corresponds to one LM, and one LM separately controls an operating voltage and a frequency of one core by using one LDO. In this embodiment of the present invention, an operating voltage and a frequency of each core can be regulated flexibly according to a load status of the core. Each core in a multi-core architecture operates in an optimal power-saving state, so as to reduce overall power consumption of the multi-core architecture.

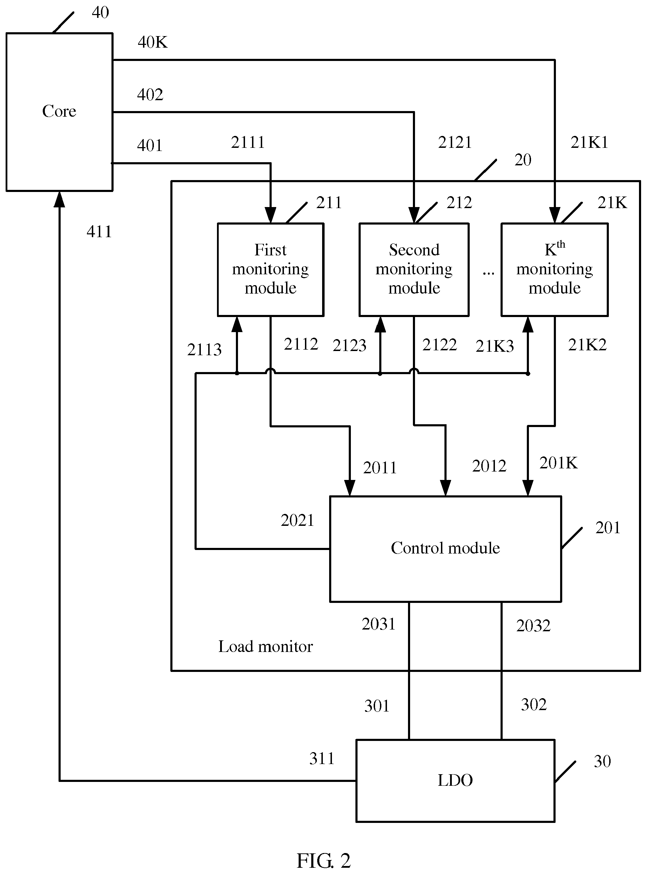

Referring to FIG. 2, FIG. 2 is a schematic structural diagram of a load monitor according to an embodiment of the present invention. The load monitor shown in FIG. 2 is applied to the multi-core architecture in FIG. 1. As shown in FIG. 2, a load monitor 20 is configured to monitor a load status of a core 40, generate a voltage control signal according to the load status, and send the voltage control signal to an LDO 30. The LDO 30 outputs a voltage to the core 40 according to the voltage control signal. The load monitor 20 includes a control module 201 and at least one monitoring module (for example, a first monitoring module 211, a second monitoring module 212, ..., and a K^{th} monitoring module 21K shown in FIG. 2).

A monitoring end of a monitoring module is connected to an output end of the core 40. For example, a monitoring end 2111 of the first monitoring module 211 is connected to an output end 401 of the core 40, a monitoring end 2121 of the second monitoring module 212 is connected to an output end 402 of the core 40, ..., and a monitoring end 21K1 of the K^{th} monitoring module 21K is connected to an output end 40K of the core 40. An output end of a monitoring module is connected to an input end of the control module 201. For example, an output end 2112 of the first monitoring module 211 is connected to an input end 2011 of the control module 201, an output end 2122 of the second monitoring module 212 is connected to an input end 2012 of the control module 201, ..., and an output end 21K2 of the K^{th} monitoring module 21K is connected to an input end 201K of the control module 201. A control end 2021 of the control module 201 is connected to an input end of at least one monitoring module (for example, a monitoring end 2113 of the first monitoring module 211, a monitoring end 2123 of the second monitoring module 212, ..., and a monitoring end 21K3 of the K^{th} monitoring module 21K), and an output end of the control module 201 is connected to a control end of the LDO 30. For example, an output end 2031 of the control module 201 is connected to a control end 301 of the LDO 30, and an output end 2032 of the control module 201 is connected to a control end 302 of the LDO 30. An output end 311 of the LDO 30 is connected to a voltage input end 411 of the core. The control module 201 may control, by using the control end 2021, at least one monitoring module to operate or power off.

When one monitoring module operates, the one monitoring module monitors one load status of the core 40. For example, when the first monitoring module 211, the second monitoring module 212, ..., and the K^{th} monitoring module 21K operate, the first monitoring module 211 may monitor a voltage load status of the core 40, the second monitoring module 212 may monitor a current load status of the core 40, ..., and the K^{th} monitoring module 21K may monitor an idle time percentage of the core 40. These monitoring modules send the load statuses of the core 40 to the control module. For example, the first monitoring module 211 sends the voltage load status of the core to the control module 201, the second monitoring module 212 sends the current load status of the core to the control module 201, ..., and the K^{th} monitoring module 21K sends the idle time percentage of the core 40 to the control module 201. The control module 201 generates a voltage control signal according to received K load statuses of the core 40, and sends the voltage control signal to the LDO 30. The voltage control signal is used to control the LDO 30 to output a corresponding voltage to the core 40, and the LDO 30 is configured to output, according to different voltage control signals, different voltages to supply power to the core 40.

In a specific scenario, the control end 2021 of the control module 201 sends a start signal to the K monitoring modules (for example, the first monitoring module 211, the second monitoring module 212, ..., and the K^{th} monitoring module 21K shown in FIG. 2), so as to start the foregoing K monitoring modules to monitor the load status of the core 40. Each monitoring module can monitor one type of load status of the core 40. For example, the first monitoring module 211 monitors wait for interrupt duration of the core 40, the second monitoring module 212 monitors a cache hit rate of the core 40, and the K^{th} monitoring module 21K monitors the idle time percentage of the core 40. The foregoing K monitoring modules send K detected load statuses to the control module 201. The control module 201 generates voltage control signals according to the foregoing load statuses, and sends the voltage control signals to the LDO 30. The LDO 30 outputs, according to the foregoing voltage control signals, a voltage to supply power to the core 40.

In an embodiment, it may be determined, according to a load status, whether to regulate a voltage and frequency of the core. If the load status is the wait for interrupt duration, the first monitoring module 211 monitors the wait for interrupt duration of the core 40. When the first monitoring module 211 detects that the wait for interrupt duration of the core 40 is within preset duration (for example, 20 to 50 microseconds), the LDO does not regulate the voltage and frequency of the core 40, and keeps the voltage and frequency of the core 40 unchanged. When the first monitoring module 211 detects that the wait for interrupt duration of the core 40 is less than a preset value (for example, 20 microseconds), the LDO raises the voltage and frequency of the core 40. When the first monitoring module 211 detects that the wait for interrupt duration of the core 40 is greater than another preset value (for example, 50 microseconds), the LDO lowers the voltage and frequency of the core 40.

If the load status is the cache hit rate, the second monitoring module 212 monitors the cache hit rate of the core 40. When the second monitoring module 212 detects that the cache hit rate of the core 40 is within a preset cache hit rate range (for example, 50% to 80%), the LDO does not regulate the voltage and frequency of the core 40, and keeps the voltage and frequency of the core 40 unchanged. When the second monitoring module 212 detects that the cache hit rate of the core 40 is less than a first cache hit rate threshold (for example, 50%), the LDO lowers the voltage and frequency of the core 40. When the second monitoring module 212 detects that the cache hit rate of the core 40 is greater than a second cache hit rate threshold (for example, 80%), the LDO raises the voltage and frequency of the core 40.

If the load status is the idle time percentage, the K^{th} monitoring module 21K monitors the idle time percentage of the core 40. When the K^{th} monitoring module 21K detects that the idle time percentage of the core 40 is within a preset idle time percentage range (for example, 20% to 80%), the LDO does not regulate the voltage and frequency of the core 40, and keeps the voltage and frequency of the core 40 unchanged. When the K^{th} monitoring module 21K detects that the idle time percentage of the core 40 is less than a first idle time percentage threshold (for example, 20%), the LDO lowers the voltage and frequency of the core 40. When the K^{th} monitoring module 21K detects that the idle time percentage of the core 40 is greater than a second idle time percentage threshold (for example, 80%), the LDO raises the voltage and frequency of the core 40.

If the load status includes the wait for interrupt duration, the cache hit rate, and the idle time percentage, a weight of each load status may be set, and a preset weight value range may be set to determine whether a sum of weight values of all the load statuses is within the preset weight value range. If the sum of the weight values of all the load statuses is within the preset weight value range, the LDO does not regulate the voltage and frequency of the core 40. If the sum of the weight values of all the load statuses is not within the preset weight value range, the LDO raises or lowers the voltage and frequency of the core 40. For example, the preset weight value range is set to 2 to 4. When the wait for interrupt duration is within the preset duration (for example, 20 to 50 microseconds), a corresponding weight value is 1. When the wait for interrupt duration is less than the preset value (for example, 20 microseconds), a corresponding weight value is 0. When the wait for interrupt duration is greater than the another preset value (for example, 50 microseconds), a corresponding weight value is 2. When the cache hit rate is within the preset cache hit rate range (for example, 50% to 80%), a corresponding weight value is 1. When the cache hit rate is less than the first cache hit rate threshold (for example, 50%), a corresponding weight value is 2. When the cache hit rate is greater than the second cache hit rate threshold (for example, 80%), a corresponding weight value is 0. When the idle time percentage is within the preset idle time percentage range (for example, 20% to 80%), a corresponding weight value is 1. When the idle time percentage is less than the first idle time percentage threshold (for example, 20%), a corresponding weight value is 2. When the idle time percentage is greater than the second idle time percentage threshold (for example, 80%), a corresponding weight value is 0. When the sum of the weight values of all the load statuses is from 2 to 4, the LDO keeps the voltage and frequency of the core 40 unchanged, and does not regulate the voltage and frequency of the core 40. When the sum of the weight values of all the load statuses is less than 2, the LDO raises the voltage and frequency of the core 40. When the sum of the weight values of all the load statuses is greater than 4, the LDO lowers the voltage and frequency of the core 40.

When the other load statuses are unchanged, shorter wait for interrupt duration indicates heavier core load and a lower voltage and frequency required by the core, and longer wait for interrupt duration indicates lighter core load and a higher voltage and frequency required by the core. When the other load statuses are unchanged, a higher cache hit rate indicates heavier core load and a higher voltage and frequency required by the core, and a lower cache hit rate indicates lighter core load and a lower voltage and frequency required by the core. When the other load statuses are unchanged, a larger idle time percentage indicates lighter core load and a lower voltage and frequency required by the core, and a smaller idle time percentage indicates heavier core load and a higher voltage and frequency required by the core.

According to the load monitor shown in FIG. 2, the load monitor can regulate an operating voltage and a frequency of a core according to a load status of the core. In a multi-core architecture, each load monitor can regulate, according to a load status of a core connected to the load monitor, an operating voltage of the core, and further adjust an operating frequency of the core, so as to meet a requirement for different voltages and frequencies of multiple cores in the multi-core architecture, and reduce overall power consumption of the multi-core architecture.

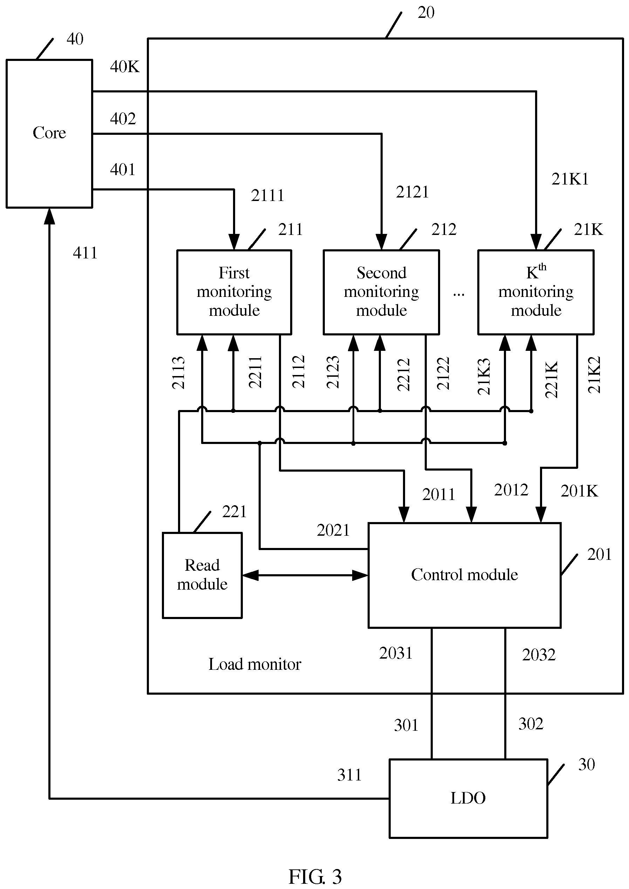

Referring to FIG. 3, FIG. 3 is a schematic structural diagram of another load monitor according to an embodiment of the present invention. The load monitor shown in FIG. 3 is applied to the multi-core architecture in FIG. 1. FIG. 3 is obtained from optimization further performed based on FIG. 2. As shown in FIG. 3, a load monitor 20 is configured to connect an LDO 30 and a core 40. The load monitor 20 includes a control module 201, at least one monitoring module (for example, a first monitoring module 211, a second monitoring module 212, ..., and a K^{th} monitoring module 21K shown in FIG. 3), and a read module 221.

The read module 221 is configured to control the at least one monitoring module and the control module 201 to operate or power off, and read, when the at least one monitoring module and the control module 201 operate, at least one load status from the at least one monitoring module.

The load status read by the read module 221 may be used by an external device, a system, or software. The external device, system, or software can obtain a load status of a core in time to facilitate monitoring on the load status of the core performed by the external device, system, or software.

The load status includes a load signal. When the control module 201 operates, the control module 201 periodically outputs a sampling signal to all the monitoring modules (for example, the first monitoring module 211, the second monitoring module 212, ..., and the K^{th} monitoring module 21K shown in FIG. 3). In response to the sampling signal, each monitoring module samples a load signal inputted by the core 40. In a sampling period of the sampling signal, when a monitoring module determines that the load signal is greater than a corresponding threshold, the monitoring module determines that the load signal is valid. Each monitoring module counts a quantity of times that the load signal is valid in the sampling period, and latches a load value of the valid load signal, so that the read module 221 reads the load value.

In this embodiment of the present invention, the load signal may include load signals such as load power, a load voltage, a load current, and the like that are of the core 40. Each load signal has a corresponding threshold. For example, the load power has a corresponding power threshold, the load voltage has a corresponding voltage threshold, and the load current has a corresponding load current. The load power is used as an example below. In a sampling period, when the load power is greater than the corresponding power threshold, a monitoring module configured to monitor power determines that the load power is valid, and latches a power value of the valid load power. The monitoring module configured to monitor power can count a quantity of times that the load power is valid in the sampling period. The read module 221 can read the quantity of the times that the load power is valid. Because the monitoring module configured to monitor power can latch the power value of the valid load power, the read module 221 can read the power value of the valid load power. This embodiment of the present invention provides an operating manner of the read module. The read module can periodically read the load status of the core.

In a specific scenario, as shown in FIG. 3, when the control module 201 operates, the control module 201 periodically outputs the sampling signal to the K monitoring modules (for example, the first monitoring module 211, the second monitoring module 212, ..., and the K^{th} monitoring module 21K shown in FIG. 3). For example, the first monitoring module 211 is configured to monitor the load power of the core 40, the second monitoring module 212 is configured to monitor the load voltage of the core 40, and the K^{th} monitoring module 21K is configured to monitor the load current of the core 40. In response to the sampling signal, the first monitoring module 211 samples the load power inputted by the core 40; in response to the sampling signal, the second monitoring module 212 samples the load voltage inputted by the core 40; and in response to the sampling signal, the K^{th} monitoring module 21K samples the load current inputted by the core 40. In a sampling period of the sampling signal, when the first monitoring module 211 detects that the load power inputted by the core 40 is greater than the corresponding power threshold, the first monitoring module 211 determines that the load power is valid, and latches the power value of the valid load power, so that the read module 221 reads the power value. The first monitoring module 211 counts the quantity of the times that the load power is valid in the sampling period, so that the read module 221 reads the quantity of the times that the load power is valid in the sampling period. The first monitoring module 211 may further send the quantity of the times that the load power is valid in the sampling period to the control module 201, so that the control module obtains the load power of the core 40 according to the quantity of the times that the load power is valid in the sampling period. When the second monitoring module 212 detects that the load voltage inputted by the core 40 is greater than the corresponding voltage threshold, the second monitoring module 212 determines that the load voltage is valid, and latches the voltage value of the valid load voltage, so that the read module 221 reads the voltage value. The second monitoring module 212 counts a quantity of times that the load voltage is valid in the sampling period, so that the read module 221 reads the quantity of the times that the load voltage is valid in the sampling period. The second monitoring module 212 may further send the quantity of the times that the load voltage is valid in the sampling period to the control module 201, so that the control module obtains the load voltage of the core 40 according to the quantity of the times of the valid load voltage is valid in the sampling period. When the K^{th} monitoring module 21K detects that the load current inputted by the core 40 is greater than the corresponding current threshold, the K^{th} monitoring module 21K determines that the load current is valid, and latches the current value of the valid load current, so that the read module 221 reads the current value. The K^{th} monitoring module 21K counts a quantity of times that the load current is valid in the sampling period, so that the read module 221 reads the quantity of the times that the load current is valid in the sampling period. The K^{th} monitoring module 21K may further send the quantity of the times that the load current is valid in the sampling period to the control module 201, so that the control module obtains the load current of the core 40 according to the quantity of the times that the load current is valid in the sampling period.

Optionally, the voltage control signal includes an operating mode control signal. The operating mode control signal is used to control the LDO 30 to be in different operating modes, and in different operating modes, the LDO 30 outputs different voltages to supply power to the core.

In this embodiment of the present invention, the operating mode control signal may be represented by a binary bit stream. For example, a 1-bit binary bit stream can represent two different operating modes ("0" and "1" respectively represent two different operating modes.). A 2-bit binary bit stream can represent four different operating modes ("00", "01", "10", and "11" respectively represent four different operating modes.). As shown in FIG. 3, after the control module 201 generates the voltage control signal, the control module 201 outputs the operating mode control signal to the LDO 30 by using the output end 2031 and the output end 2032. For example, when the output end 2031 and the output end 2032 respectively output "0" and "0", the LDO 30 is in a first operating mode. When the output end 2031 and the output end 2032 respectively output "0" and "1", the LDO 30 is in a second operating mode. When the output end 2031 and the output end 2032 respectively output "1" and "0", the LDO 30 is in a third operating mode. When the output end 2031 and the output end 2032 respectively output "1" and "1", the LDO 30 is in a fourth operating mode. In different operating modes, the LDO 30 outputs different voltages to supply power to the core.

In this embodiment of the present invention, multiple operating modes may be set for an LDO. In different operating modes, the LDO outputs different voltages to a core. The LDO determines its operating mode according to a voltage control signal outputted by a load monitor, so as to regulate a voltage and a frequency of the core. The LDO itself does not need to control an output voltage. Only the operating mode of the LDO needs to be set. A design of the LDO is simplified, and the load monitor can rapidly regulate the voltage and the frequency of the core.

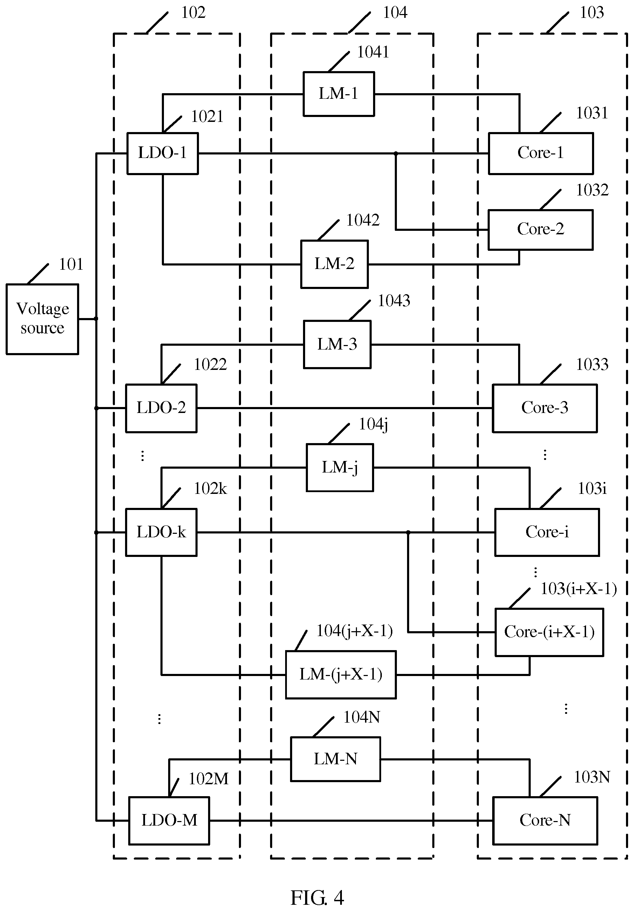

Referring to FIG. 4, FIG. 4 is a schematic structural diagram of a power supply system based on a multi-core architecture according to an embodiment of the present invention, including a voltage source 101, N cores (for example, 1031, 1032, ..., and 103N in FIG. 4), M low dropout regulators LDOs (for example 1021, 1022, ..., and 102M in FIG. 4), and N load monitors LMs (1041, 1042, ..., and 104N).

An output end of the voltage source 101 is connected to input ends of the M LDOs. An output end of a k^{th} LDO 102k is connected to voltage input ends of X cores (103i to 103(i+X-1)). A signal output end of an i^{th} core 103i is connected to a monitoring end of a j^{th} LM 104j. An output end of the j^{th} LM 104j is connected to a control end of the k^{th} LDO 102k. Each LDO is connected to a different core. For example, as shown in FIG. 4, the LDO 1021 is connected to the core 1031 and the core 1032. The LDO 1022 is connected to a core 1033. The LDO 102k is connected to the core 103(i+X-1). The LDO 102M is connected to the core 103N. One core is connected to one LM. Each core is connected to a different LM. For example, the core 1031 is connected to the LM 1041, the core 1032 is connected to the LM 1042, the core 1033 is connected to the LM 1043, ..., and the core 103N is connected to the LM 104N. M and N are positive integers greater than or equal to 2. N is greater than or equal to M. X is a positive integer less than N. The k^{th} LDO 102k is any one of the M LDOs. The i^{th} core 103i is any one of the X cores. The j^{th} LM 104j is any one of the N LMs. Both i and j are positive integers.

The voltage source 101 provides a supply voltage for the M LDOs. The j^{th} LM 104j monitors a load status of the i^{th} core 103i, generates a voltage control signal according to the load status, and sends the voltage control signal to the k^{th} LDO 102k. The k^{th} LDO 102k receives X voltage control signals sent by X LMs, determines a highest voltage control signal from the X voltage control signals, and outputs, according to a correspondence between a voltage control signal and an output voltage, a target output voltage corresponding to the highest voltage control signal to the X cores. The target output voltage is less than or equal to the supply voltage.

In this embodiment of the present invention, a power supply system based on a multi-core architecture includes at least two LDOs. One LDO can control an operating voltage of at least one core. A voltage outputted by an LDO is controlled by an LM connected to the LDO. Each LM can output a voltage control signal to an LDO according to a load status of a core detected by the LM. The LDO outputs, according to the voltage control signal, a voltage to supply power to the core. When this embodiment of the present invention is implemented, the LM can control a supply voltage of the core according to the load status of the core detected by the LM, so as to meet a requirement for different voltages of multiple cores in the multi-core architecture, and reduce overall power consumption of the multi-core architecture.

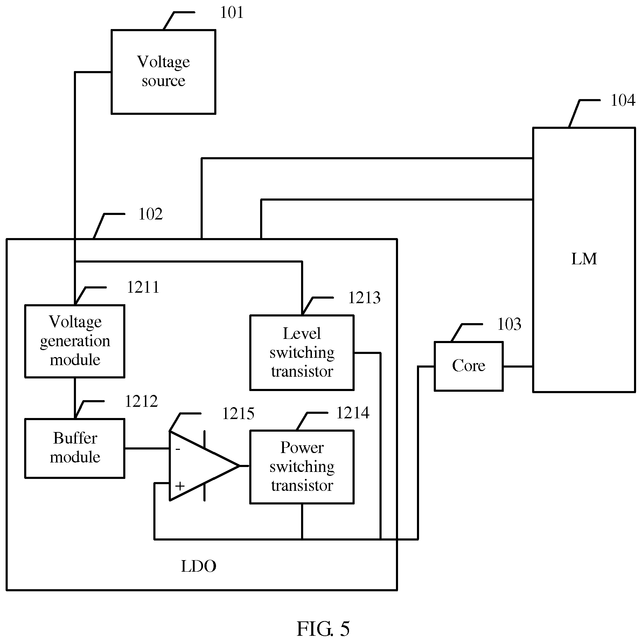

Optionally, referring to FIG. 5, FIG. 5 is a schematic structural diagram of an LDO according to an embodiment of the present invention. As shown in FIG. 5, an LDO 102 includes a voltage generation module 1211, a buffer module 1212, a level switching transistor 1213, a power switching transistor 1214, and a voltage comparator 1215.

After detecting a load status of a core 103, an LM 104 outputs two enable signals to the LDO 102. The foregoing two enable signals act on the cache module 1212 and power switching transistor 1214, so as to affect a voltage inputted by an inverting input end of the voltage comparator 1215. A non-inverting input end of the voltage comparator 1215 is connected to an operating voltage of the core 103. When the voltage inputted by the inverting input end of the voltage comparator 1215 is greater than a voltage inputted by the non-inverting input end of the voltage comparator 1215, the power switching transistor 1214 controls to raise the voltage of the non-inverting input end of the voltage comparator 1215, so as to raise the operating voltage of the core 103. When the voltage inputted by the inverting input end of the voltage comparator 1215 is less than the voltage inputted by the non-inverting input end of the voltage comparator 1215, the power switching transistor 1214 controls to lower the voltage of the non-inverting input end of the voltage comparator 1215, so as to reduce the operating voltage of the core 103. When the voltage inputted by the inverting input end of the voltage comparator 1215 is equal to the voltage inputted by the non-inverting input end of the voltage comparator 1215, the power switching transistor 1214 does not operate, and does not change the operating voltage of the core 103.

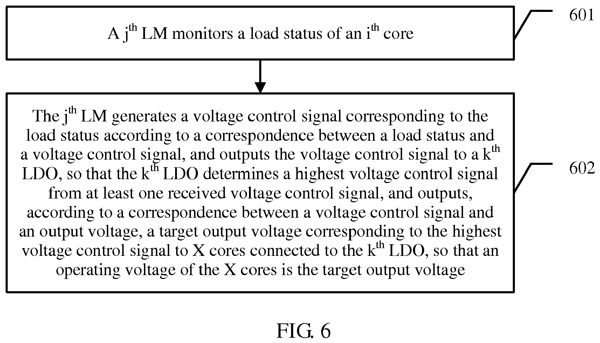

Referring to FIG. 6, FIG. 6 is a schematic flowchart of a voltage regulation method according to an embodiment of the present invention. The voltage regulation method in this embodiment of the present invention is applied to the power supply system that is based on a multi-core architecture shown in FIG. 4. As shown in FIG. 6, the voltage regulation method includes following steps.

601. A j^{th} LM monitors a load status of an i^{th} core.

In this embodiment of the present invention, the j^{th} LM 104j is any one of N LMs. The i^{th} core 103i is any one of X cores. One core is connected to one LM. Each core is connected to a different LM. The load status may include parameters such as a load ratio, a voltage, a current, power, and a frequency that are of the core, and may also include parameters such as wait for interrupt duration, a cache hit rate, and an idle time percentage that are of the core. Generally, shorter wait for interrupt duration, a higher cache hit rate, and a smaller idle time percentage of a core all indicate heavier core load.

602. The j^{th} LM generates a voltage control signal corresponding to the load status according to a correspondence between a load status and a voltage control signal, and outputs the voltage control signal to a k^{th} LDO, so that the k^{th} LDO determines a highest voltage control signal from at least one received voltage control signal, and outputs, according to a correspondence between a voltage control signal and an output voltage, a target output voltage corresponding to the highest voltage control signal to X cores connected to the k^{th} LDO, so that an operating voltage of the X cores is the target output voltage.

In this embodiment of the present invention, when the i^{th} core 103i is in different load statuses, the i^{th} core 103i requires different supply voltages. Heavier load of the i^{th} core 103i indicates a higher voltage and frequency required. Lighter load of the i^{th} core 103i indicates a lower voltage and frequency required. For the correspondence between a load status and a voltage control signal, reference may be made to the foregoing FIG. 1 to FIG. 4, and details are not described herein. After receiving voltage control signals sent by X LMs (104j to 104(j+X-1)), the LDO 102k determines a highest voltage control signal from the X received voltage control signals, and outputs a target output voltage corresponding to the highest voltage control signal to the X cores (the core 103i to a core 103 (i+X-1)) connected to the k^{th} LDO 102k, so that the operating voltage of the X cores is the target output voltage.

Preferably, if X is equal to 1, the foregoing M and N are equal, that is, one LDO corresponds to one core, one core corresponds to one LM, and one LM independently controls an operating voltage of one core by using one LDO. In this embodiment of the present invention, an operating voltage of each core can be regulated flexibly according to a load status of the core. Each core in a multi-core architecture operates in an optimal power-saving state, so as to reduce overall power consumption of the multi-core architecture.

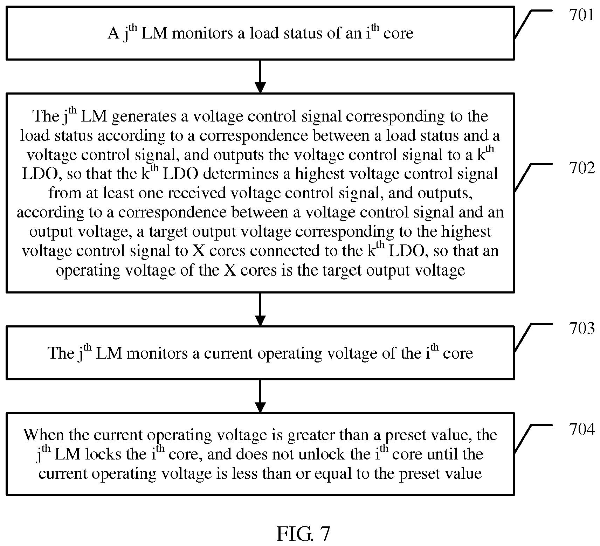

Referring to FIG. 7, FIG. 7 is a schematic flowchart of another voltage regulation method according to an embodiment of the present invention. FIG. 7 is obtained from optimization further performed based on FIG. 6. As shown in FIG. 7, the voltage regulation method includes following steps.

701. A j^{th} LM monitors a load status of an i^{th} core.

702. The j^{th} LM generates the voltage control signal corresponding to the load status according to the correspondence between a load status and voltage control signal, and outputs the voltage control signal to a k^{th} LDO, so that the k^{th} LDO determines a highest voltage control signal from at least one received voltage control signal, and outputs, according to the correspondence between a voltage control signal and an output voltage, the target output voltage corresponding to the highest voltage control signal to X cores connected to the k^{th} LDO, so that the operating voltage of the X cores is the target output voltage.

For specific implementations of step 701 and step 702 in this embodiment of the present invention, reference may be made to step 601 and step 602 shown in FIG. 6, and details are not described again in this embodiment of the present invention.

703. The j^{th} LM monitors a current operating voltage of the i^{th} core.

704. When the current operating voltage is greater than a preset value, the j^{th} LM locks the i^{th} core, and unlocks the i^{th} core only when the current operating voltage is less than or equal to the preset value.

Each core has a highest safe operating voltage, that is, the preset value in this embodiment of the present invention. When an LM detects that a current operating voltage of a core is greater than the preset value, the LM locks the core, and unlocks the core only when the current operating voltage is less than or equal to the preset value. In this embodiment of the present invention, locking a core is a method for ensuring core performance when an operating voltage of the core is excessively high. Locking a core can stabilize an operating current of the core, and avoid, when a voltage required by the core is excessively high, a problem that an unstable voltage outputted by an LDO results in an unstable operating current.

Step 703 and step 704 may be performed before step 701, and may also be performed after step 702, and this is not limited in this embodiment of the present invention.

Optionally, the voltage control signal includes a first enable signal and a second enable signal. A magnitude of the voltage control signal is determined based on the first enable signal and the second enable signal, and different voltage control signals correspond to different operating modes.

The first enable signal may be "0" or "1". The second enable signal may also be "0" or "1". A combination of the first enable signal and second enable signal may correspond to four types of different voltage control signals. Each type of voltage control signal corresponds to one type of operating mode. Different voltage control signals correspond to different operating modes.

Optionally, the k^{th} LDO includes the following four operating modes: an active mode, a retention mode, a bypass mode, and a power-off mode.

In the active mode (English: Active mode), a voltage and a current that are instantaneously outputted to the core by the LDO can meet a requirement for normal operation of the core. In this case, the core is in an operating state.

In the retention mode (English: Retention mode), the LDO outputs a very low voltage. In this case, the LDO is also in a low-power-consumption state, and the core is in a non-operating state, and retains only necessary internal status information. Most power consumption of the core comes from static power consumption.

In the bypass mode (English: Bypass mode), a voltage outputted by the LDO is provided totally by an external voltage source. The voltage outputted by the LDO is a voltage of the external voltage source.

In the power-off mode (English: Power off mode), a power supply of the core is totally powered off, and the core stops operating.

For example, that the first enable signal is "1", and the second enable signal is "0" corresponds to a first type of voltage control signal, and the first type of voltage control signal corresponds to the power-off mode. That the first enable signal is "0", and the second enable signal is "1" corresponds to a second type of voltage control signal, and the second type of voltage control signal corresponds to the bypass mode. That the first enable signal is "1", and the second enable signal is "0" corresponds to a third type of voltage control signal, and the third type of voltage control signal corresponds to the retention mode. That the first enable signal is "1", and the second enable signal is "1" corresponds to a fourth type of voltage control signal, and the fourth type of voltage control signal corresponds to the active mode.

Optionally, the load status includes at least one of an idle time percentage, wait for interrupt duration, a temperature, or a cache hit rate.

In this embodiment of the present invention, a larger idle time percentage indicates lighter core load. Longer wait for interrupt duration indicates lighter core load. A higher temperature indicates heavier core load. A higher cache hit rate indicates heavier core load. A load status includes one or multiple combinations of the idle time percentage, wait for interrupt duration, temperature, and cache hit rate.

The above describes in detail a load monitor, a power supply system based on a multi-core architecture, and a voltage regulation method that are disclosed in this embodiment of the present invention. In this specification, specific examples are used to describe the principle and implementations of the present invention, and the description of the embodiments is only intended to help understand the method and core idea of the present invention. Meanwhile, a person of ordinary skill in the art may, based on the idea of the present invention, make modifications with respect to the specific implementations and the application scope. Therefore, the content of this specification shall not be construed as a limitation to the present invention.

## Claims

1. A power supply system based on a multi-core architecture, comprising a voltage source (101) and N cores (103), and further comprising M low dropout regulators (102), LDOs, and N load monitors, LMs, wherein
each of the N LMs (104) is configured to monitor a load status of a core (103) of the N cores (103), and control, according to the load status of the core (103), a low dropout regulator (102), LDO, of the M LDOs (102) to output a voltage to the core (103), and each of the LMs (104) comprises a control module and at least one monitoring module, wherein
a monitoring end of the monitoring module is connected to a signal output end of the core (103), an output end of the monitoring module is connected to an input end of the control module, a control end of the control module is connected to an input end of the monitoring module, an output end of the control module is connected to a control end of the LDO (102), an output end of the LDO (102) is connected to a voltage input end of the core (103), and the control module is configured to control the monitoring module to operate or power off; and
when the monitoring module operates, the monitoring module is adapted to monitor the load status of the core (103) and to send the load status of the core (103) to the control module, the control module is adapted to generate, according to the load status of the core (103), a voltage control signal and to send the voltage control signal to the LDO (102), the voltage control signal being suitable for controlling the LDO (102) to output a corresponding voltage to the core (103), and the LDO (102) is configured to output, according to different voltage control signals, different voltages to supply power to the core (103); and wherein
an output end of the voltage source (101) is connected to input ends of the M LDOs (102), an output end of a k^{th} LDO (102) is connected to voltage input ends of X cores (103), a signal output end of an i^{th} core is connected to a monitoring end of a j^{th} LM (104), and an output end of the j^{th} LM (104) is connected to a control end of the k^{th} LDO (102), wherein each LDO (102) is connected to a different core (103), or to a different plurality of X cores, one core (103) is connected to one LM (104), each core (103) is connected to a different LM (104), M is a positive integer greater than or equal to 2, N is a positive integer greater than M, X is a positive integer greater than or equal to 2 and less than N, the k^{th} LDO (102) is any one of the M LDOs (102), the i^{th} core (103) is any one of the X cores (103), the j^{th} LM (104) is any one of the N LMs (104), and both i and j are positive integers; and
the voltage source (101) is configured to provide a supply voltage for the M LDOs (102), the j^{th} (104) is adapted to monitor a load status of the i^{th} core (103), to generate a voltage control signal according to the load status, and to send the voltage control signal to the k^{th} LDO (102), the k^{th} LDO (102) is adapted to receive X voltage control signals sent by X LMs (104), to determine a highest voltage control signal from the X voltage control signals, and to output, according to a correspondence between a voltage control signal and an output voltage, a target output voltage corresponding to the highest voltage control signal to the X cores (103); and the target output voltage is less than or equal to the supply voltage.

2. The power supply system according to claim 1, wherein each of the N LMs (104) further comprises a read module, the read module is connected to the monitoring module and the control module, the read module is configured to control the monitoring module and the control module to operate or power off, and when the monitoring module and the control module operate, read the load status detected by the monitoring module.

3. The power supply system according to claim 2, wherein the load status comprises a load signal;
when the control module operates, the control module periodically outputs a sampling signal to the monitoring module, and in response to the sampling signal, the monitoring module samples a load signal inputted by the core; in a sampling period of the sampling signal, when the load signal is greater than a corresponding threshold, the monitoring module determines that the load signal is valid; and the monitoring module counts a quantity of times that the load signal is valid during the sampling period, and latches a load value of the valid load signal, so that the read module reads the load value.

4. The power supply system according to any one of claims 1 to 3, wherein the voltage control signal comprises an operating mode control signal, the operating mode control signal is used to control the LDO (102) to be in different operating modes, and in different operating modes, the LDO (102) outputs different voltages to supply power to the core (103).

5. A voltage regulation method, applied to the system according to claim 4, wherein the method comprises:
Monitoring (601), by a j^{th} LM, a load status of an i^{th} core; and
Generating (602), by the j^{th} LM according to a correspondence between a load status and a voltage control signal, a voltage control signal corresponding to the load status, and outputting the voltage control signal to a k^{th} LDO, so that the k^{th} LDO determines a highest voltage control signal from at least two received voltage control signals and outputs, according to a correspondence between a voltage control signal and an output voltage, a target output voltage corresponding to the highest voltage control signal to the X cores connected to the k^{th} LDO, so that an operating voltage of the X cores is the target output voltage.

6. The method according to claim 5, wherein the method further comprises:
monitoring, by the j^{th} LM, a current operating voltage of the i^{th} core; and
locking, by the j^{th} LM, the i^{th} core when the current operating voltage is greater than a preset value, and unlocking the i^{th} core only when the current operating voltage is less than or equal to the preset value.

7. The method according to claim 5 or 6, wherein the voltage control signal comprises a first enable signal and a second enable signal, a magnitude of the voltage control signal is determined based on the first enable signal and the second enable signal, and different voltage control signals correspond to different operating modes.

8. The method according to claim 7, wherein the k^{th} LDO comprises the following four operating modes: an active mode, a retention mode, a bypass mode, and a power-off mode.

9. The method according to any one of claims 5 to 8, wherein the load status comprises at least one of an idle time percentage, wait for interrupt duration, a temperature, or a cache hit rate.

## Patentansprüche

1. Stromversorgungssystem, basierend auf einer mehradrigen Architektur, welches eine Spannungsquelle (101) und N Adern (103) und außerdem M "Low-Dropout"-Regler (102), LDOs, und N Lastüberwachungen ("load monitors", LMs) umfasst, wobei jede der N LMs (104) dafür eingerichtet ist, einen Lastzustand einer Ader (103) der N Adern (103) zu überwachen und gemäß dem Lastzustand der Ader (103) einen "Low-Dropout"-Regler (102), LDO, der M LDOs (102) zu steuern, um eine elektrische Spannung an die Ader (103) auszugeben, und wobei jede der LMs (104) ein Steuermodul und mindestens ein Überwachungsmodul umfasst, wobei
ein Überwachungsende des Überwachungsmoduls an ein Signalausgangsende der Ader (103) angeschlossen ist, ein Ausgangsende des Überwachungsmoduls an ein Eingangsende des Steuermoduls angeschlossen ist, ein Steuerungsende des Steuermoduls an ein Eingangsende des Überwachungsmoduls angeschlossen ist, ein Ausgangsende des Steuermoduls an ein Steuerungsende des LDO (102) angeschlossen ist, ein Ausgangsende des LDO (102) an ein Spannungseingangsende der Ader (103) angeschlossen ist, und das Steuermodul dafür eingerichtet ist, das Überwachungsmodul zu steuern, um zu arbeiten oder abzuschalten; und
wenn das Überwachungsmodul arbeitet, das Überwachungsmodul dafür geeignet ist, den Lastzustand der Ader (103) zu überwachen und den Lastzustand der Ader (103) an das Steuermodul zu senden, wobei das Steuermodul dafür geeignet ist, gemäß dem Lastzustand der Ader (103) ein Spannungssteuersignal zu erzeugen und das Spannungssteuersignal an den LDO (102) zu senden, wobei das Spannungssteuersignal dafür geeignet ist, den LDO (102) zu steuern, um eine entsprechende elektrische Spannung an die Ader (103) auszugeben, und wobei der LDO (102) dafür eingerichtet ist, unterschiedliche elektrische Spannungen gemäß unterschiedlichen Spannungssteuersignalen auszugeben, um die Ader (103) mit Strom zu versorgen; und wobei
ein Ausgangsende der Spannungsquelle (101) an Eingangsenden der M LDOs (102) angeschlossen ist, ein Ausgangsende eines k-ten LDO (102) an Spannungseingangsenden von X Adern (103) angeschlossen ist, ein Signalausgangsende einer i-ten Ader an ein Überwachungsende einer j-ten LM (104) angeschlossen ist, und ein Ausgangsende der j-ten LM (104) an ein Steuerungsende des k-ten LDO (102) angeschlossen ist, wobei jeder LDO (102) an eine andere Ader (103) oder eine andere Mehrzahl von X Adern angeschlossen ist, eine Ader (103) an eine LM (104) angeschlossen ist, jede Ader (103) an eine andere LM (104) angeschlossen ist, M eine positive Ganzzahl größer oder gleich 2 ist, N eine positive Ganzzahl größer als M ist, X eine positive Ganzzahl größer oder gleich 2 und kleiner als N ist, der k-te LDO (102) ein beliebiger der M LDOs (102) ist, die i-te Ader (103) eine beliebige der X Adern (103) ist, die j-te LM (104) eine beliebige der N LMs (104) ist, und sowohl i als auch j positive Ganzzahlen sind; und
die Spannungsquelle (101) dafür eingerichtet ist, eine Versorgungsspannung für die M LDOs (102) zu liefern, die j-te LM (104) dafür geeignet ist, einen Lastzustand der i-ten Ader (103) zu überwachen, dem Lastzustand gemäß ein Spannungssteuersignal zu erzeugen und das Spannungssteuersignal an den k-ten LDO (102) zu senden, der k-te LDO (102) dafür geeignet ist, X von den X LMs (104) gesendete Spannungssteuersignale zu empfangen, ein höchstes Spannungssteuersignal von den X Spannungssteuersignalen zu bestimmen, und, gemäß einer Korrespondenz zwischen einem Spannungssteuersignal und einer Ausgangsspannung, eine Zielausgangsspannung entsprechend dem höchsten Spannungssteuersignal an die X Adern (103) auszugeben; und wobei die Zielausgangsspannung kleiner oder gleich der Versorgungsspannung ist.

2. Stromversorgungssystem nach Anspruch 1, wobei jede der N LMs (104) außerdem ein Lesemodul umfasst, wobei das Lesemodul an das Überwachungsmodul und das Steuermodul angeschlossen ist, wobei das Lesemodul dafür eingerichtet ist, das Überwachungsmodul und das Steuermodul zu steuern, um zu arbeiten oder abzuschalten, und, wenn das Überwachungsmodul und das Steuermodul arbeiten, den vom Überwachungsmodul erkannten Lastzustand auszulesen.

3. Stromversorgungssystem nach Anspruch 2, wobei der Lastzustand ein Lastsignal umfasst;
wobei, wenn das Steuermodul arbeitet, das Steuermodul periodisch ein Abtastsignal an das Überwachungsmodul ausgibt, und als Reaktion auf das Abtastsignal das Überwachungsmodul ein von der Ader eingespeistes Lastsignal abtastet; wobei in einer Abtastperiode des Abtastsignals, wenn das Lastsignal größer als ein entsprechender Schwellenwert ist, das Überwachungsmodul bestimmt, dass das Lastsignal gültig ist; und wobei das Überwachungsmodul eine Anzahl von Malen zählt, dass das Lastsignal während der Abtastperiode gültig ist, und einen Lastwert des gültigen Lastsignals festhält, damit das Lesemodul den Lastwert ausliest.

4. Stromversorgungssystem nach einem der Ansprüche 1 bis 3, wobei das Spannungssteuersignal ein Betriebsmodus-Steuersignal umfasst, wobei das Betriebsmodus-Steuersignal dazu genutzt wird, den LDO (102) zu steuern, um sich in unterschiedlichen Betriebsmodi zu befinden, und wobei der LDO (102) in unterschiedlichen Betriebsmodi unterschiedliche elektrische Spannungen ausgibt, um die Ader (103) mit Strom zu versorgen.

5. Spannungsregelungsverfahren, angewendet auf das System nach Anspruch 4, wobei das Verfahren Folgendes umfasst:
Überwachen (601), durch eine j-te LM, eines Lastzustands einer i-ten Ader; und
Erzeugen (602) eines Spannungssteuersignals entsprechend dem Lastzustand durch die j-te LM gemäß einer Korrespondenz zwischen einem Lastzustand und einem Spannungssteuersignal, und Ausgeben des Spannungssteuersignals an einen k-ten LDO, damit der k-te LDO ein höchstes Spannungssteuersignal aus mindestens zwei empfangenen Spannungssteuersignalen bestimmt, und gemäß einer Korrespondenz zwischen einem Spannungssteuersignal und einer Ausgangsspannung eine Zielausgangsspannung entsprechend dem höchsten Spannungssteuersignal an die X an den k-ten LDO angeschlossenen Adern ausgibt, damit eine Betriebsspannung der X Adern die Zielausgangsspannung ist.

6. Verfahren nach Anspruch 5, wobei das Verfahren außerdem Folgendes umfasst:
Überwachen, durch die j-te LM, einer aktuellen Betriebsspannung der i-ten Ader; und
Sperren, durch die j-te LM, der i-ten Ader, wenn die aktuelle Betriebsspannung größer als ein voreingestellter Wert ist, und Entsperren der i-ten Ader erst dann, wenn die aktuelle Betriebsspannung kleiner oder gleich dem voreingestellten Wert ist.

7. Verfahren nach Anspruch 5 oder 6, wobei das Spannungssteuersignal ein erstes Aktivierungssignal und ein zweites Aktivierungssignal umfasst, wobei die Größenordnung des Spannungssteuersignals basierend auf dem ersten Aktivierungssignal und dem zweiten Aktivierungssignal bestimmt wird, und wobei unterschiedliche Spannungssteuersignale unterschiedlichen Betriebsmodi entsprechen.

8. Verfahren nach Anspruch 7, wobei der k-te LDO die folgenden vier Betriebsmodi umfasst: einen Aktivmodus, einen Beibehaltungsmodus, einen Bypassmodus und einen Abschaltmodus.

9. Verfahren nach einem der Ansprüche 5 bis 8, wobei der Lastzustand mindestens eines von Folgendem umfasst: einen Inaktivzeit-Prozentsatz, eine Warten-auf-Unterbrechung-Zeitdauer, eine Temperatur oder eine Cache-Trefferrate.

## Revendications

1. Système d'alimentation en courant basé sur une architecture multi-coeurs, comprenant une source de tension (101) et N coeurs (103), et comprenant en outre M régulateurs à faible chute de tension (102), LDO, et N moniteurs de charge, LM, dans lequel :
chacun des N LM (104) est configuré pour surveiller un état de charge d'un coeur (103) des N coeurs (103), et pour commander, en fonction de l'état de charge du coeur (103), un régulateur à faible chute de tension (102), LDO, des M LDO (102), pour qu'il envoie une tension au coeur (103), et chacun des LM (104) comprend un module de commande et au moins un module de surveillance,
une extrémité de surveillance du module de surveillance étant connectée à une extrémité de sortie de signal du coeur (103), une extrémité de sortie du module de surveillance étant connectée à une extrémité d'entrée du module de commande, une extrémité de commande du module de commande étant connectée à une extrémité d'entrée du module de surveillance, une extrémité de sortie du module de commande étant connectée à une extrémité de commande du LDO (102), une extrémité de sortie du LDO (102) étant connectée à une extrémité d'entrée de tension du coeur (130), et le module de commande étant configuré pour commander le module de surveillance de façon qu'il fonctionne ou qu'il s'éteigne ; et
lorsque le module de surveillance fonctionne, le module de surveillance étant adapté pour surveiller l'état de charge du coeur (103) et envoyer l'état de charge du coeur (103) au module de commande, le module de commande étant adapté pour générer, en fonction de l'état de charge du coeur (103), un signal de commande de tension, et envoyer le signal de commande de tension au LDO (102), le signal de commande de tension étant approprié pour commander le LDO (102) de façon qu'il envoie une tension correspondante au coeur (103), et le LDO (102) étant configuré pour envoyer, en fonction des différents signaux de commande de tension, différentes tensions d'alimentation au coeur (103) ; et dans lequel
une extrémité de sortie de la source de tension (101) est connectée aux extrémités d'entrée des M LDO (102), une extrémité de sortie d'un k^{ème} LDO (102) est connectée aux extrémités d'entrée de tension de X coeurs (103), une extrémité de sortie de signal d'un i^{ème} coeur est connectée à une extrémité de surveillance d'un j^{ème} LM (104), et une extrémité de sortie du j^{ème} LM (104) est connectée à une extrémité de commande du k^{ème} LDO (102), chaque LDO (102) étant connecté à un coeur différent (103), ou à une pluralité différente de X coeurs, un coeur (103) étant connecté à un LM (104), chaque coeur (103) étant connecté à un LM (104) différent, M étant un entier positif supérieur ou égal à 2, N étant un entier positif supérieur à M, X étant un entier positif supérieur ou égal à 2 et inférieur à N, le k^{ème} LDO (102) étant l'un quelconque des M LDO (102), le i^{ème} coeur (103) étant l'un quelconque des X coeurs (103), le j^{ème} LM (104) étant l'un quelconque des N LM (104), et i et j étant tous les deux des entiers positifs ; et
la source de tension (101) est configurée pour produire une tension d'alimentation pour les M LDO (102), le j^{ème} LM (104) est adapté pour surveiller un état de charge du i^{ème} coeur (103), générer un signal de commande de tension en fonction de l'état de charge, et envoyer le signal de commande de tension au k^{ème} LDO (102), le k^{ème} LDO (102) est adapté pour recevoir X signaux de commande de tension envoyés par X LM (104), déterminer un signal de commande de tension de plus forte intensité parmi les X signaux de commande de tension, et envoyer, en fonction d'une correspondance entre un signal de commande de tension et une tension de sortie, une tension de sortie cible correspondant au signal de commande de tension de plus forte intensité aux X coeurs (103) ; et la tension de sortie cible est inférieure ou égale à la tension d'alimentation.

2. Système d'alimentation en courant selon la revendication 1, dans lequel chacun des N LM (104) comprend en outre un module de lecture, le module de lecture étant connecté au module de surveillance et au module de commande, le module de lecture étant configuré pour commander le module de surveillance et le module de commande de façon qu'ils fonctionnent ou qu'ils s'éteignent, et, lorsque le module de surveillance et le module de commande fonctionnent, lire l'état de charge détecté par le module de surveillance.

3. Système d'alimentation en courant selon la revendication 2, dans lequel l'état de charge comprend un signal de charge ;
lorsque le module de commande fonctionne, le module de commande envoie périodiquement un signal d'échantillonnage au module de surveillance, et, en réponse au signal d'échantillonnage, le module de surveillance échantillonne un signal de charge introduit par le coeur ; dans une période d'échantillonnage du signal d'échantillonnage, lorsque l'intensité du signal de charge est plus élevée qu'un seuil correspondant, le module de surveillance détermine que le signal de charge est valide ; et le module de surveillance compte une quantité de temps pendant laquelle le signal de charge est valide pendant la période d'échantillonnage, et verrouille une valeur de charge du signal de charge valide, de telle sorte que le module de lecture lise la valeur de charge.

4. Système d'alimentation en courant selon l'une quelconque des revendications 1 à 3, dans lequel le signal de commande de tension comprend un signal de commande de mode de fonctionnement, le signal de commande de mode de fonctionnement étant utilisé pour commander le LDO (102) pour le mettre dans différents modes de fonctionnement et, dans les différents modes de fonctionnement, le LDO (102) envoie des tensions d'alimentation différentes au coeur (103).

5. Procédé de régulation de tension, appliqué au système selon la revendication 4, lequel procédé comprend :
la surveillance (601), par un j^{ème} LM, d'un état de charge d'un i^{ème} coeur ; et
la génération (602), par le j^{ème} LM, en fonction d'une correspondance entre un état de charge et un signal de commande de tension, un signal de commande de tension correspondant à l'état de charge, et l'envoi du signal de commande de tension à un k^{ème} LDO, de telle sorte que le k^{ème} LDO détermine un signal de commande de tension de plus forte intensité parmi au moins deux signaux de commande de tension reçus, et envoie, en fonction d'une correspondance entre un signal de commande de tension et une tension de sortie, une tension de sortie cible correspondant au signal de commande de tension de plus forte intensité aux X coeurs connectés au k^{ème} LDO, de telle sorte qu'une tension de fonctionnement des X coeurs soit la tension de sortie cible.

6. Procédé selon la revendication 5, lequel procédé comprend en outre :
la surveillance, par le j^{ème} LM, d'une tension de fonctionnement courante du i^{ème} coeur ; et
le verrouillage, par le j^{ème} LM, du i^{ème} coeur lorsque la tension de fonctionnement courante est supérieure à une valeur prédéfinie, et le déverrouillage du i^{ème} coeur uniquement lorsque la tension de fonctionnement courante est inférieure ou égale à la valeur prédéfinie.

7. Procédé selon la revendication 5 ou 6, dans lequel le signal de commande de tension comprend un premier signal d'activation et un deuxième signal d'activation, une amplitude du signal de commande de tension étant déterminée en fonction du premier signal d'activation et du deuxième signal d'activation, et des signaux de commande de tension différents correspondant à des modes de fonctionnement différents.

8. Procédé selon la revendication 7, dans lequel le k^{ème} LDO comprend les quatre modes de fonctionnement suivants : mode actif, mode rétention, mode dérivation et mode extinction.

9. Procédé selon l'une quelconque des revendications 5 à 8, dans lequel l'état de charge comprend au moins l'un d'un pourcentage de temps de veille, d'une attente pendant une durée d'interruption, d'une température, ou d'un taux de présence en mémoire cache.
